# FASCICULE DE BREVET EUROPEEN

(11) **EP 2 812 126 B1**
(45) Date de publication et mention de la délivrance du brevet: **28.12.2016**
(21) Numéro de dépôt: 13703398.1
(22) Date de dépôt: 08.02.2013
(51) Int. Cl.: B05D 1/20

(54) **PROCEDE DE DEPOT DE PARTICULES SUR UN SUBSTRAT, COMPRENANT UNE ETAPE DE STRUCTURATION D'UN FILM DE PARTICULES SUR UN CONVOYEUR LIQUIDE**
VERFAHREN ZUR ABLAGERUNG VON PARTIKELN AUF EINEM SUBSTRAT MIT EINEM SCHRITT ZUR STRUKTURIERUNG EINES PARTIKELFILMS AUF EINEM FLÜSSIGFÖRDERER
METHOD FOR DEPOSITING PARTICLES ONTO A SUBSTRATE, INCLUDING A STEP OF STRUCTURING A PARTICLE FILM ON A LIQUID CONVEYOR

(30) Priorité: 10.02.2012 FR 1251255
(43) Date de publication de la demande: 17.12.2014
(73) Titulaire: Commissariat à l'Énergie Atomique et aux Énergies Alternatives, 75015 Paris (FR)
(72) Inventeur: DELLEA, Olivier, F-42350 La Talaudiere (FR); CORONEL, Philippe, F-38530 Barraux (FR); DESAGE, Simon, Frédéric, F-42400 Saint-chamond (FR); FUGIER, Pascal, F-38190 Bernin (FR)
(74) Mandataire: Brevalex
(86) Numéro de dépôt international: PCT/EP2013/052502
(87) Numéro de publication internationale: WO 2013/117679

(56) Documents cités:
- WO-A1-99/38623
- WO-A1-03/095108
- WO-A2-01/89716
- US-A1- 2005 281 944
- SACHIN KINGE ET AL: "Self-Assembling Nanoparticles at Surfaces and Interfaces", CHEMPHYSCHEM, vol. 9, no. 1, 11 janvier 2008 (2008-01-11), pages 20-42, XP055042089, ISSN: 1439-4235, DOI: 10.1002/cphc.200700475 cité dans la demande

## Description

### DOMAINE TECHNIQUE

L'invention se rapporte au domaine des procédés pour le dépôt de particules sur un substrat, de préférence en défilement.

Plus précisément, elle concerne le dépôt d'un film de particules ordonnées, de préférence du type monocouche, dont la taille des particules peut être comprise entre quelques nanomètres et plusieurs centaines de micromètres. Les particules, de préférence de forme sphérique, peuvent par exemple être des particules de silice.

L'invention se rapporte essentiellement à une étape de structuration du film de particules avant son dépôt sur le substrat, cette structuration visant à mettre le film en forme afin par exemple d'y intégrer d'autres particules, et/ou des objets. Une autre possibilité consiste à prévoir des zones évidées de particules, entourées par le film qui reste ordonné.

Dans le cas de l'intégration d'objets dans le film, il s'agit en particulier de fabriquer des dispositifs à caractère hybride, comme par exemple des capteurs. A titre indicatif, un dispositif hybride associe par définition sur un même substrat des objets ayant diverses fonctions, par exemple électroniques, optiques, électro-optiques, piézo-électriques, thermoélectriques, mécaniques, etc.

Les objets à intégrer au film de particules sont par exemple :
- des composants électroniques actifs, tels que des transistors, microprocesseurs, circuits intégrés, etc. ;
- des composants passifs de l'électronique, comme des résistances, capacités, diodes, photodiodes, bobines, pistes conductrices, préformes de soudure, etc. ;
- des composants optiques, tels que des lentilles, microlentilles, réseaux de diffraction, filtres, etc. ;
- des piles, micro-piles, micro-batteries, photo-détecteurs, cellules solaires, système RFID, etc. ;
- des particules ou agrégats nano ou micrométriques, actifs ou passifs, par exemple du type oxydes, polymères, métaux, semi-conducteurs, Janus (particules ayant deux faces de natures ou propriétés différentes), nanotubes, etc.

Plus particulièrement, l'invention concerne l'intégration d'objets dont les dimensions s'étendent :
- pour les composants : de l'échelle microscopique (quelques dizaines de microns), à l'échelle macroscopique (plus d'une dizaine de centimètres) ; et
- pour les particules et agrégats : du nanomètre à plusieurs centaines de microns.

Plus généralement, l'invention présente des applications dans le domaine des piles à combustible, de l'optique, de la photonique, du revêtement de polymère, des puces, des MEMs, de la structuration de surface pour l'électronique organique et le photovoltaïque, etc.

### ÉTAT DE LA TECHNIQUE ANTÉRIEURE

Pour le dépôt de films de particules ordonnées, il a récemment été développé une technique de transfert d'un film de particules ordonnées sur un substrat, via un convoyeur liquide. Néanmoins, les techniques usuelles de structuration ne s'avèrent pas adaptées lorsqu'il s'agit de transférer le film, préalablement organisé, sur un substrat par l'intermédiaire d'un convoyeur liquide.

### EXPOSÉ DE L'INVENTION

L'invention a donc pour but de remédier au moins partiellement à l'inconvénient mentionné ci-dessus. Pour ce faire, l'invention a pour objet un procédé de dépôt de particules sur un substrat, de préférence en défilement, comprenant les étapes suivante :
(a) réalisation d'un moins un premier film compact de particules flottant sur un liquide porteur prévu dans une zone de transfert présentant une sortie de particules agencée en regard dudit substrat ;
(b) réalisation d'au moins un motif par dépôt d'une substance sur ledit premier film compact de particules dans la zone de transfert, le long d'un contour dudit motif, ladite substance maintenant les unes aux autres les particules du film au contact de cette substance ;
(c) retrait d'au moins une partie des particules du premier film situées intérieurement par rapport audit contour, ou extérieurement par rapport à ce dernier ; puis
(d) transfert des motifs sur ledit substrat, par ladite sortie de particules.

L'invention apporte ainsi une solution simple et efficace permettant de structurer un film de particules ordonnées avant de le déposer sur le substrat, cette structuration visant à mettre le film en forme afin par exemple d'y intégrer des particules différentes, et/ou des objets, ou tout simplement en laissant l'intérieur des motifs vide de particules.

Selon un premier mode de réalisation préféré de l'invention, l'étape (c) consiste à retirer lesdites particules situées intérieurement par rapport à chaque contour, cette étape étant éventuellement suivie, avant l'étape (d), d'une étape de mise place d'un ou plusieurs autres éléments, sur le liquide porteur dans la zone évidée délimitée par chaque contour, l'étape (d) étant réalisée en déplaçant ensemble chaque motif et ledit premier film à travers ladite sortie de particules, et, le cas échéant, avec ledit un ou plusieurs autres éléments.

Parmi les éléments envisagés pour être placés dans les zones évidées, il est cité des puces en silicium, des micro-batteries, des composants de l'électronique organique, des éléments métalliques, des cellules photovoltaïques, des piles et micro-piles. Ces éléments permettent notamment de fabriquer des dispositifs à caractère hybride, comme par exemple des capteurs. Comme évoqué ci-dessus, les motifs peuvent être laissés vides de particules jusqu'à leur dépôt sur le substrat conjointement avec le premier film, et éventuellement remplis ultérieurement après le dépôt.

Alternativement, d'autres particules peuvent être logées dans les zones évidées.

Selon un second mode de réalisation préféré, l'étape (c) consiste à retirer lesdites particules situées extérieurement par rapport à chaque contour, cette étape étant suivie, avant l'étape (d), d'une étape de réalisation d'un second film compact de particules (4) flottant sur le liquide porteur dans la zone de transfert, autour de chaque contour, l'étape (d) étant réalisée en déplaçant ensemble chaque motif et ledit second film à travers ladite sortie de particules.

Il est noté que les motifs contenant les particules ordonnées peuvent être déplacés les uns par rapport aux autres avant la formation du second film de particules dans la zone de transfert. Ici, ledit second film peut être réalisé à l'aide de particules différentes de celles dudit premier film, par exemple avec une composition et/ou une taille distinctes. Cela permet notamment de former un film avec des gradients qui est ensuite déposé sur le substrat.

Selon un troisième mode de réalisation préféré de l'invention, l'étape (a) consiste à réaliser une pluralité de premiers films compacts de particules respectivement dans différentes parties séparées de ladite zone de transfert, l'étape (b) consiste à réaliser au moins un motif sur chaque premier film compact, l'étape (c) consiste à retirer, dans chacune desdites parties de ladite zone de transfert, lesdites particules situées extérieurement par rapport à chaque contour, les motifs sont ensuite éventuellement déplacés relativement les uns par rapport aux autres sur le liquide porteur, et il est ensuite réalisé, avant l'étape (d), une étape de réalisation d'un second film compact de particules flottant sur le liquide porteur dans la zone de transfert, autour desdits motifs, l'étape (d) consistant à transférer ensemble lesdits motifs et le second film à travers ladite sortie de particules.

Ici également, ledit second film est réalisé à l'aide de particules différentes de celles desdits premiers films, qui sont eux-mêmes de préférence réalisés avec des particules différentes, en matériau et/ou en taille.

De préférence, ladite substance comprend un composé polymérisable, qui est polymérisé après son dépôt sur le premier film compact de particules.

L'utilisation d'une telle substance polymérisable se révèle tout à fait adaptée au contexte de transfert d'objets par convoyeur liquide. En particulier, lors de son application, toute substance polymérisable est capable de s'adapter aux éventuelles différences de niveaux entre les particules du premier film. Ainsi, le matériau utilisé s'adapte au contour du motif géométrique créé. Il peut également s'adapter à la surface ou à la courbure éventuelle du substrat sur lequel le film est ensuite transféré.

Cette substance, une fois polymérisée, forme un ou plusieurs cordons solides qui peuvent être des connecteurs électriques, thermiques, optiques, ou mécaniques, par exemple destinés à relier deux ou plusieurs objets. Alternativement, les cordons peuvent être dépourvus de toute autre fonction que celle de délimiter des creux, ultérieurement remplis ou non, et dans ce cas ils peuvent être éliminés après leur transfert sur le substrat.

D'autres types de substances peuvent être retenus, toujours de manière à assurer le maintien des particules au contact de la substance, même après l'étape (c) de retrait des particules laissant apparaître le contour. Cela permet de conserver la forme du motif avant la formation du second film de particules, ou avant le remplissage du motif préalablement évidé, en fonction du mode de réalisation mis en oeuvre.

Dans le cas préféré d'une substance contenant un composé polymérisable, la polymérisation s'effectue par toute technique réputée appropriée par l'homme du métier, de préférence thermique ou optique. Elle est complète ou partielle avant l'étape (c), ou bien initiée après cette étape. Dans tous les cas, lors de l'étape (c), la substance se trouve dans un état permettant le maintien de la géométrie du motif malgré le retrait des particules ordonnées au sein ou en dehors de ce motif, que cette substance soit partiellement ou totalement polymérisée, voire pas encore polymérisée.

De préférence, au moment du transfert sur le substrat, la substance qui adhère aux particules à son contact, qu'elle soit ou non polymérisée, reste suffisamment souple de manière à supporter une éventuelle flexion lors du passage de la zone de transfert au substrat.

En fonction des besoins rencontrés, le diamètre des cordons obtenus peut être entre quelques dizaines de microns et plusieurs millimètres.

De préférence, ladite substance se présente sous la forme d'un liquide ou d'une pâte.

De préférence, ladite substance présente un caractère hydrophobe, et de préférence aussi à l'état solide polymérisé du cordon.

De manière plus générale, tenant notamment compte des cas où le liquide porteur n'est pas de l'eau, il est noté que la substance se révèle non-miscible avec le liquide porteur.

De préférence, ladite substance est à base de résine silicone, de résine époxy, et/ou une résine polyuréthane.

De préférence, afin de donner au contour du motif une fonction de conducteur électrique et/ou de conducteur thermique, ladite substance comprend au moins certaines particules prises parmi les matériaux suivantes :
- noir de carbone ;
- nanotubes de carbone ;
- graphène
- fibres, telles que des fibres de carbone, d'acier d'aluminium, de cuivre ;
- poudres métalliques ; et
- des oxydes de métaux.

Pour le premier mode de réalisation mentionné ci-dessus, dans le cas particulier d'une implantation d'un objet dans la zone évidée du motif, le contour entouré du premier film compact permet de maintenir en position les objets sur le liquide porteur, puis de le convoyer jusqu'au substrat. En effet, dans cette solution, le contour définit une rupture de niveau avec le liquide porteur. C'est cette rupture de niveau qui enserre l'objet, permettant ainsi de le maintenir en position et de le transporter jusqu'au substrat. Le transfert des objets peut par conséquent s'effectuer avec précision sur le substrat, de manière simple, fiable, et répétitive.

Le premier film compact de particules s'apparente donc à une plate-forme permettant d'accueillir des objets homogènes ou hétérogènes, nanoscopiques, microscopiques ou macroscopiques. Cette plate-forme peut elle-même être composée d'un ensemble homogène ou hétérogène de particules nanométriques ou microscopiques, de préférence de compositions différentes de celles des objets à transférer. De plus, comme évoqué ci-dessus, le film compact de particules peut être formé de particules hétérogènes. Ces particules peuvent aussi être fonctionnalisées à leur surface pour que se forme un lien physique entre particules, par exemple de type polymère, afin de renforcer la cohésion et donc la portance du film compact.

De préférence, le rapport entre la grande dimension des particules du premier film compact et celle des objets à transférer est compris entre 10⁴ et 10⁸. A titre d'exemple, les particules formant le premier film compact peuvent présenter une grande dimension de l'ordre de 1 nm à 500 µm, tandis que les objets convoyés par ce film peuvent quant à eux présenter une grande dimension allant jusqu'à environ 30 cm.

De préférence, les particules du premier film compact sont des billes de silice d'environ 1 µm de diamètre. Il est néanmoins noté que le film peut être hétérogène, à savoir comporter des billes de tailles différentes.

De préférence, chaque objet à transférer présente une grande dimension supérieure à 0,2 cm, et de préférence inférieure à 30 cm. Cette dernière valeur peut être adaptée en fonction de la largeur de la zone de transfert. En effet, la grande dimension de chaque objet peut atteindre une valeur proche de la largeur précitée. Des objets de taille micrométrique ou nanométrique peuvent également être déposés/transférés, sans sortir du cadre de l'invention.

De préférence, chaque objet à transférer présente au moins une partie à caractère hydrophobe. Cela est prévu de manière à assurer la flottaison de l'objet, en plaçant cette partie au contact du liquide porteur. Cette face de contact avec le liquide peut être totalement hydrophobe ou comporter un agencement de zones hydrophiles et hydrophobes, utiles au dispositif final.

L'objet à transférer, dont certains exemples ont été cités précédemment, peut être de toute forme, non-nécessairement plane, éventuellement présentant un ou plusieurs rayons de courbure, par exemple inférieur à 5 cm, ou encore intégrant des plots utiles pour la connectique. De même, pour les particules du premier film, les formes peuvent être variées, mais sont de préférence homogènes.

Par le biais de ce premier mode de réalisation, il est également visé la fabrication de dispositifs complexes comme par exemple des capteurs comprenant des éléments de détections (des particules par exemple), un ou plusieurs systèmes de récupération d'énergie (cellule photovoltaïque, film piézoélectrique, pile à combustible), un système de stockage de l'énergie (micro-batterie), un système de gestion de l'information (puce en Silicium), un système de communication (puce RFID), des éléments de liaison électrique (pistes conductrices), des composants électroniques (résistances, condensateurs), des éléments de soudure (préformes). Les objets nécessaires à l'obtention de ces dispositifs sont alors agencés en conséquence sur le convoyeur liquide, et étant au besoin superposés.

Il est par ailleurs noté que le premier film compact de particules, dont le concept est par exemple divulgué dans le document Sachin Kinge, "Self-Assembling Nanoparticles at Surfaces and Interfaces", ChemPhysChem 2008, 9, 20-42, peut être obtenu à la surface du liquide porteur par toute technique connue de l'homme du métier, par exemple par compression, et/ou interaction dipôle-dipôle, et/ou par champ magnétique, etc.

La technique par interaction dipôle-dipôle s'applique pour les particules à facettes, par exemple tétraédriques, cubiques ou encore octaédriques. Avec ces formes, les interactions dipôle-dipôle jouent un rôle important dans l'organisation des particules. Les moments dipolaires sont générés à l'intérieur de ces particules, à cause des différences de polarité entre les facettes.

La technique d'organisation par champ magnétique est employée avec des nanoparticules magnétiques pouvant être ordonnées en utilisant un champ magnétique intense, générant des interactions fortes entre les particules.

La technique par compression est notamment connue du document Lucio Isa et al., "Particle Lithography from Colloidal Self-Assembly at Liquid_Liquid Interfaces", acsnano, VOL. 4 ▪ NO. 10 ▪ 5665-5670 ▪ 2010, du document Markus Retsch, « Fabrication of Large-Area, Transférable Colloidal Monolayers Utilizing Self-Assembly at the Air/Water Interface", Macromol. Chem. Phys. 2009, 210, 230-241, ou encore du document Maria Bardosova, « The Langmuir-Blodgett Approach to Making Colloidal Photonic Crystals from Silica Spheres", Adv. Mater. 2010, 22, 3104-3124.

Cette technique par compression comprend également la solution à rampe inclinée décrite dans le document CA 2 695 449. Ainsi, le procédé selon l'invention met préférentiellement en oeuvre une rampe inclinée de circulation des particules, rattachée à une entrée de la zone de transfert, et sur laquelle ledit liquide porteur est également destiné à circuler.

Une partie de l'énergie nécessaire à l'ordonnancement des particules en régime normal est alors ici amenée par la rampe inclinée transportant le liquide porteur et les particules. D'autres solutions sont néanmoins possibles, comme la mise en mouvement, à l'aide d'une pompe, du liquide porteur sur un plan horizontal dont la partie aval constitue la zone de transfert des particules. Une autre solution consiste à remplacer la pompe par une soufflerie permettant d'appliquer un flux d'air à la surface du liquide porteur, sur lequel flottent les particules et les objets à transférer. Comme mentionné ci-dessus, d'autres solutions sont néanmoins envisageables, sans sortir du cadre de l'invention, comme un travail de compression des particules via une technique dite « Langmuir-Blodgett ».

Il est par ailleurs noté que le second film de particules intervenant dans les second et troisième modes de réalisation préférés sont analogues au premier film, même si les particules sont généralement prévues pour être de natures différentes. Quoiqu'il en soit, l'ensemble des possibilités décrites ci-dessus pour le premier film s'appliquent aussi pour le second film.

Enfin, postérieurement au transfert sur le substrat, le procédé intègre de préférence une étape de recuit thermique pour faciliter le dépôt et l'adhérence de ces particules, motifs et objets sur le substrat.

D'autres avantages et caractéristiques de l'invention apparaîtront dans la description détaillée non limitative ci-dessous.

### BRÈVE DESCRIPTION DES DESSINS

Cette description sera faite au regard des dessins annexés parmi lesquels ;
- la figure 1 montre une installation de dépôt selon un mode de réalisation préféré de la présente invention, en coupe schématique prise le long de la ligne I-I de la figure 2 ;
- la figure 2 représente une vue schématique de dessus de l'installation de dépôt montrée sur la figure 1 ;
- les figures 3 à 7 représentent différentes étapes d'un procédé de dépôt mis en oeuvre à l'aide de l'installation montrée sur les figures précédentes, selon un premier mode de réalisation préféré ;
- les figures 8a à 8d schématisent un procédé de dépôt selon un second mode de réalisation préféré ; et
- les figures 9a à 9d schématisent un procédé de dépôt selon un troisième mode de réalisation préféré.

### EXPOSÉ DÉTAILLÉ DE MODES DE RÉALISATION PRÉFÉRÉS

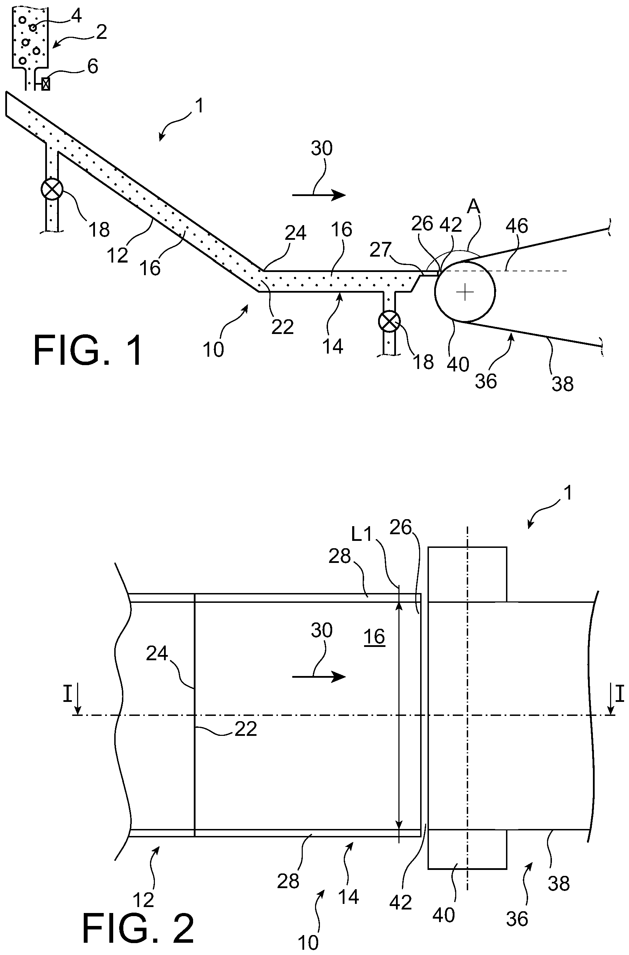

En référence tout d'abord aux figures 1 et 2, on peut apercevoir une installation 1 pour le transfert de particules sur un substrat, de préférence en défilement. Ce transfert, assimilable à un dépôt, s'effectue en formant un premier film compact de particules, qui est ensuite structuré en fonction des besoins rencontrés, comme cela sera détaillé ci-après.

L'installation 1 comporte un dispositif 2 de dispense de particules 4, dont la taille peut être comprise entre quelques nanomètres et plusieurs centaines de micromètres. Les particules, de préférence de forme sphérique, peuvent par exemple être des particules de silice. D'autres particules d'intérêt peuvent être faites de métal ou d'oxyde de métal comme le Platine, le TiO2, de polymère comme le polystyrène ou le PMMA, de carbone, etc.

Plus précisément, dans le mode de réalisation préféré, les particules sont des sphères de silice d'environ 1 µm de diamètre, stockées en solution dans le dispositif de dispense 2. La proportion du milieu est d'environ 7 g de particules pour 200 ml de solution, ici du butanol. Naturellement, pour des raisons de clarté, les particules représentées sur les figures adoptent un diamètre supérieur à leur diamètre réel.

Le dispositif de dispense 2 présente une buse d'injection 6 commandable, d'environ 500 µm de diamètre.

L'installation comporte également un convoyeur liquide 10, intégrant une rampe inclinée 12 de circulation des particules, et une zone de transfert 14 sensiblement horizontale, voire présentant une légère inclinaison de façon à favoriser la vidange de l'installation, le cas échéant. L'extrémité haute de la rampe inclinée est prévue pour recevoir les particules injectées depuis le dispositif de dispense 2. Cette rampe est droite, inclinée d'un angle compris entre 5 et 60°, de préférence entre 10 et 30°, permettant aux particules d'être acheminées vers la zone de transfert 14. De plus, un liquide porteur 16 circule sur cette rampe 12, jusque dans la zone de transfert. Ce liquide 16 peut d'ailleurs être re-circulé à l'aide d'une ou deux pompes 18, entre la zone de transfert 14 et l'extrémité haute de la rampe. Il s'agit ici de préférence d'une eau dé-ionisée, sur laquelle les particules 4 peuvent flotter. Néanmoins, on peut privilégier un liquide neuf via un circuit de circulation ouvert. Il peut aussi s'agir d'une association de plusieurs liquides non-miscibles.

L'extrémité basse de cette même rampe est raccordée à une entrée de la zone de transfert de particules 14. Cette entrée 22 se situe au niveau d'une ligne d'inflexion 24 matérialisant la jonction entre la surface du liquide porteur présent sur le plan incliné de la rampe 12, et la surface du liquide porteur présent sur la partie horizontale de la zone de transfert 14.

L'entrée de particules 22 est espacée d'une sortie de particules 26 à l'aide de deux rebords latéraux 28 retenant le liquide porteur 16 dans la zone 14. Ces rebords 28, en regard et à distance l'un de l'autre, s'étendent parallèlement à une direction principale d'écoulement du liquide porteur et des particules dans l'installation, cette direction étant schématisée par la flèche 30 sur les figures 1 et 2. La zone 14 prend par conséquent la forme d'un couloir ou d'un chemin ouvert à son entrée et à sa sortie, même si d'autres géométries pourraient être adoptées, sans sortir du cadre de l'invention.

Le fond de la partie aval de la zone de transfert présente un plateau 27 légèrement incliné vers l'amont par rapport à la direction horizontale, par exemple d'une valeur de l'ordre de 5 à 10°. C'est l'extrémité aval de ce même plateau 27, également dénommé « blade », qui définit en partie la sortie des particules 26.

L'installation 1 est également pourvue d'un convoyeur de substrat 36, destiné à mettre le substrat 38 en défilement. Ce substrat peut être rigide ou souple. Dans ce dernier cas, il peut être mis en mouvement sur un rouleau 40 dont l'axe est parallèle à la sortie 26 de la zone 14, à proximité de laquelle il se situe. En effet, le substrat 38 est destiné à défiler de manière très rapprochée de la sortie 26, afin que les particules atteignant cette sortie puisse être transférées aisément sur ce substrat, via un pont capillaire 42, également dénommé ménisque, qui le relie au liquide porteur 16. Alternativement, le substrat peut être au contact directement de la zone de transfert, sans sortir du cadre de l'invention. Le pont capillaire mentionné ci-dessus n'est alors plus requis.

A titre informatif, dans le cas où le substrat est rigide et les objets à transférer sont également rigides et ne peuvent s'adapter à une rupture d'angle lors du transfert, il peut être avantageux d'immerger le substrat dans le liquide de la zone de transfert, et d'effectuer le tirage dans cette configuration. Ceci permet de maximiser l'angle formé entre le plan horizontal du liquide de la zone de transfert, et le plan du substrat.

Dans l'exemple montré sur les figures, la largeur du substrat correspond à la largeur de la zone 14 et de sa sortie 26. Il s'agit d'une largeur L1 qui correspond aussi à la largeur maximale du film de particules qu'il est possible de déposer sur le substrat. Cette largeur peut être de l'ordre de 25 à 30 cm. La largeur du substrat sur lequel doivent être déposées les particules peut cependant être inférieure à la largeur L1.

Le pont capillaire 42 est assuré entre le liquide porteur 16 qui se situe au niveau de la sortie 26, et une partie du substrat 38 épousant le rouleau de guidage / d'entraînement 40.

De préférence, l'angle saillant A, formé entre la direction horizontale 46 et la partie du substrat 38 sur laquelle le film de particules et les objets doivent se déposer, est supérieure à 160°, et encore plus préférentiellement proche de 180°, par exemple de l'ordre de 175°.

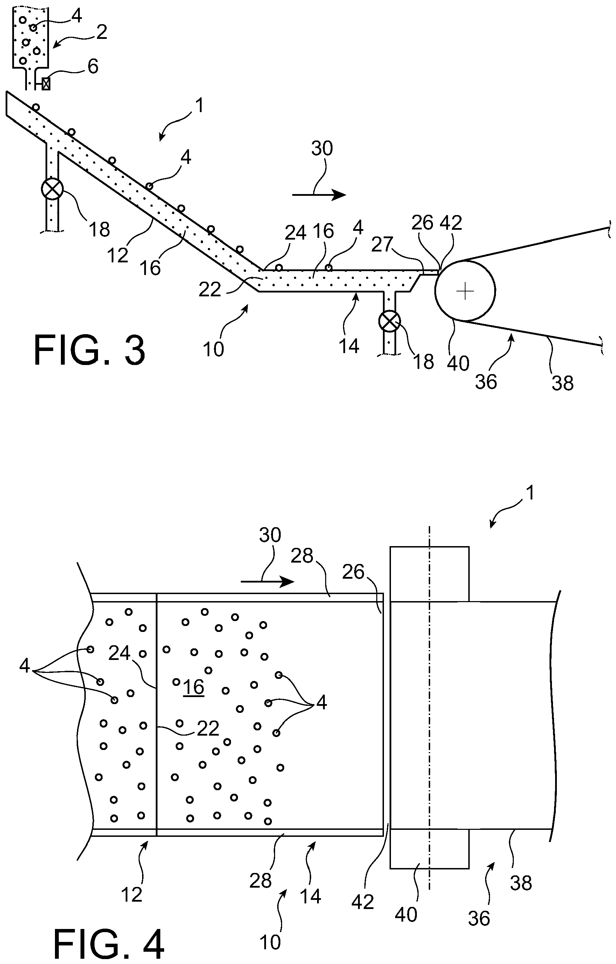

Un procédé de dépôt de particules selon un premier mode de réalisation va maintenant être décrit en référence aux figures 3 à 7e.

Tout d'abord, la buse d'injection 6 est activée pour débuter la dispense des particules 4 sur la rampe 12. Il s'agit de mettre en oeuvre une étape initiale de remplissage de la zone de transfert 14, par les particules 4, avec le liquide porteur 16 déjà au niveau requis dans la zone 14.

Durant cette phase d'amorçage, les particules dispensées par le dispositif 2 circulent sur la rampe 12, puis pénètrent dans la zone 14 dans laquelle elles se dispersent, comme cela a été schématisé sur les figures 3 et 4.

Au fur et à mesure que les particules 4 sont injectées sur la rampe 12 et pénètrent dans la zone de transfert 14, elles viennent en butée contre le substrat 38, puis le front amont de ces particules a tendance à se décaler vers l'amont, en direction de la ligne d'inflexion 24. L'injection de particules est poursuivie même après que ce front amont ait dépassé la ligne 24, afin qu'il remonte sur la rampe inclinée 12.

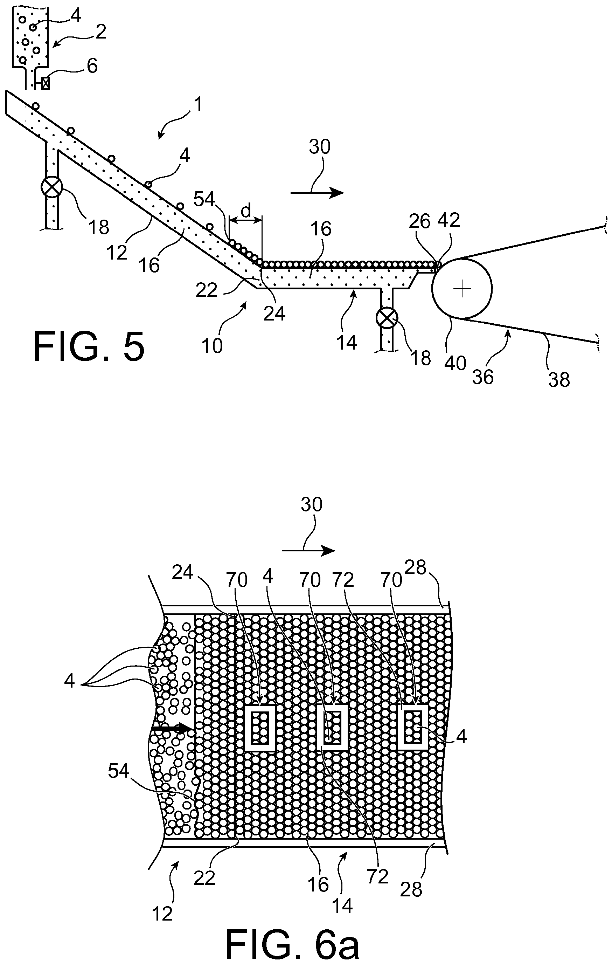

Effectivement, il est fait en sorte que le front amont de particules 54 remonte sur la rampe 12 de manière à ce qu'il se situe à une distance horizontale « d » donnée de la ligne d'inflexion 24, comme montré sur la figure 5. La distance « d » peut être de l'ordre de 30 mm.

A cet instant, les particules 4 sont ordonnées dans la zone de transfert et sur la rampe 12, sur laquelle elles s'ordonnent automatiquement, sans assistance, grâce notamment à leur énergie cinétique et aux forces capillaires mises à profit au moment de l'impact sur le front 54. L'ordonnancement est tel que le premier film compact obtenu présente une structure dite « hexagonale compacte », dans laquelle chaque particule 4 est entourée et contactée par six autres particules 4 en contact entre elles. Il est alors indifféremment parlé de film compact de particules, ou de film de particules ordonnées.

Une fois que les particules ordonnancées 4 formant le premier film recouvrent l'intégralité du liquide porteur situé dans la zone de transfert 14, il est procédé à une étape de réalisation de motifs 70 sur le film 4, par dépôt d'une substance 72 sur les particules, le long d'un contour des motifs. Pour chaque motif, après le dépôt de la substance 72, celle-ci forme le long d'une ligne fermée le contour du motif concerné. La figure 6a montre un exemple de plusieurs motifs 70 définis par leurs contours réalisés à l'aide de la substance 72 déposée, permettant de maintenir les unes par rapport aux autres les particules mouillées par la substance 72, qui est ici de préférence du type comprenant un composé polymérisable. Les particules 4 situées intérieurement et extérieurement par rapport aux contours 72 en forme de cordons restent ordonnées.

Le dépôt de la substance polymérisable s'effectue par exemple à l'aide d'une buse de dispense (non représentée). A l'arrivée au contact des particules, la substance 72 est capable de s'adapter à la topographie du premier film ordonné, et adhère aux particules 4 qu'elle recouvre.

Le composé polymérisable est par exemple une résine silicone, une résine époxy, et/ou une résine polyuréthane. La polymérisation s'effectue de manière classique, par exemple par voie thermique et/ou optique, et s'opère de préférence, au moins en partie, lorsque la substance se trouve encore dans la zone de transfert, pas encore déposée sur le substrat.

La substance 72 se présente alors sous forme de liquide ou de pâte, à laquelle des particules peuvent être ajoutées avant sa dispense afin de fonctionnaliser les connecteurs qui sont ensuite obtenus après polymérisation. Ces connecteurs peuvent avoir des fonctions électriques, thermiques, optiques, piézoélectriques et/ou mécaniques. A titre d'exemples indicatifs, pour des connecteurs électriques et/ou thermiques, les particules ajoutées peuvent être du noir de carbone, des nanotubes de carbone, du graphène, de fibres telles que des fibres de carbone, d'acier d'aluminium, de cuivre, des poudres métalliques, des oxydes de métaux.

Par ailleurs, il est indiqué que la substance est retenue de manière à ce qu'elle permette une certaine souplesse du cordon lors du transfert sur le substrat, afin de supporter la flexion lors du passage de la zone de transfert au substrat, et ce en raison de l'inclinaison A du substrat par rapport à la direction horizontale. Cette souplesse doit donc subsister après la polymérisation partielle ou totale du cordon dans la zone de transfert, avant le transfert sur le substrat.

De préférence, la substance 72 présente un caractère hydrophobe à l'état liquide, pour que celui-ci reste en surface du liquide porteur après sa dispense sur le film de particules 4, si la substance atteint cette même surface du liquide porteur. Quoi qu'il en soit, la substance 72, après son dépôt sur le premier film, adhère à ce dernier en raison de sa composition. De plus, la substance est également choisie de manière à rester insoluble dans le liquide porteur à l'état liquide, et également à l'état solide après polymérisation.

La polymérisation s'effectue donc préférentiellement avant le transfert sur le substrat, afin d'obtenir des cordons souples, de diamètre de préférence compris entre quelques dizaines de microns et plusieurs millimètres, maintenant ensemble les particules 4 qui sont à son contact et maintenant également la forme initiale des motifs.

L'étape suivante du processus de structuration du film réside dans le retrait des particules 4 situées dans les motifs 70, intérieurement par rapport aux contours formé par la substance 72. A cet égard, comme évoqué ci-dessus, il est noté que lors de la réalisation de cette étape de retrait, la substance se trouve dans un état permettant le maintien de la géométrie du motif malgré le retrait des particules ordonnées au sein des motifs, que la substance soit partiellement ou totalement polymérisée, voire non-encore polymérisée.

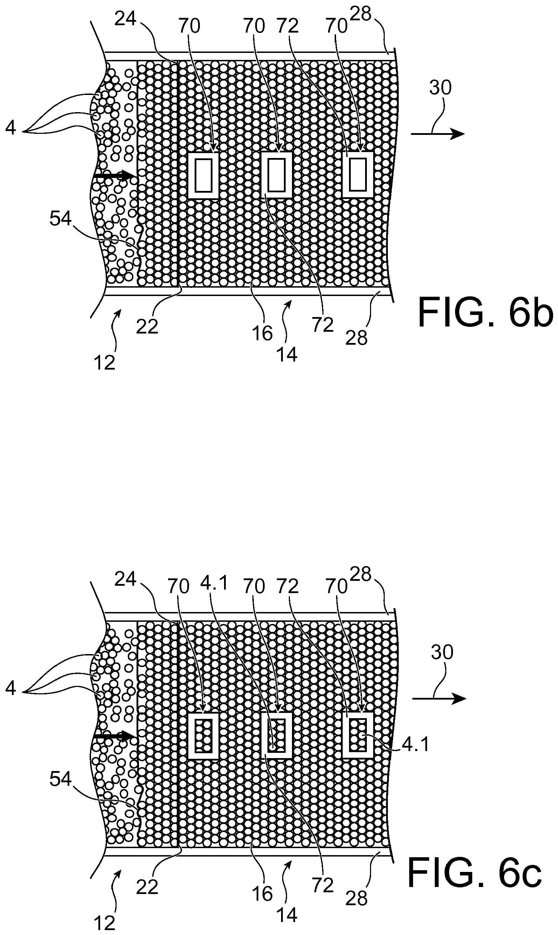

Après le retrait des particules, par exemple par simple aspiration, l'intérieur des motifs 70 est donc évidé de particules, comme cela a été schématisé sur la figure 6b.

Ensuite divers éléments peuvent être placé à l'intérieur des motifs pour remplacer les particules retirées. Ces éléments peuvent par exemple être d'autres particules 4.1, schématisées sur la figure 6c, analogues aux particules 4 mais de composition et/ou de taille différentes, injectées de manière à être à leur tour ordonnées dans les zones intérieures remplies. Ces injections peuvent être réalisées selon toute forme réputée appropriée par l'homme du métier, par exemple par microspray, par buse, par jet d'encre, ou encore par convoyeur.

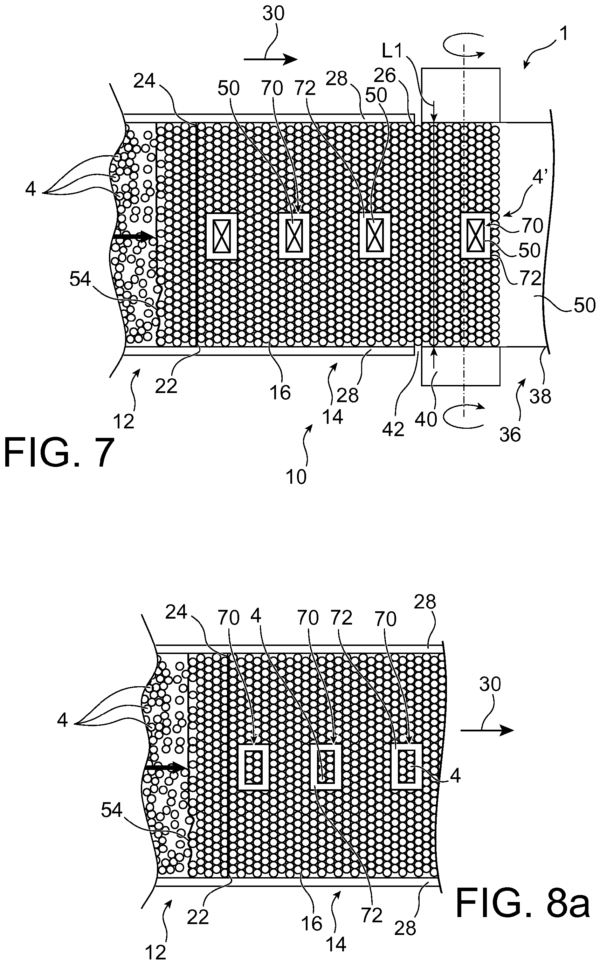

La solution à convoyeur, par exemple du type ruban ou succession de rouleaux, est aussi préférentiellement retenue dans le cas de l'intégration d'objets dans les zones évidées, par exemple pour former des dispositifs hybrides. De tels objets 50 ont été représentés schématiquement sur la figure 7, intégrés au sein du premier film 4 en étant chacun entouré par le contour 72 de l'un des motifs 70. Ce sont alors ces mêmes contours qui enserrent la périphérie de chaque objet 50, permettant ainsi de les maintenir en position les uns par rapport aux autres, ainsi que par rapport à la structure fixe de la zone de transfert. Dans le cas où l'objet 50 est de taille plus petite que celle formée par le motif, un ajout de polymère structurant peut-être envisagé pour bloquer l'objet dans le motif.

Outre la solution de convoyeur, la mise en place de ces objets peut être réalisée à l'aide d'outils de manipulation ou de préhension conventionnels adaptés à la nature, la forme et la dimension des objets, comme des pinces. Les objets 50 intégrés au premier film 4 à l'intérieur des motifs sont tenus à la surface du liquide par la tension superficielle de ce liquide.

La mise en position des objets 50 s'effectue préférentiellement en arrêtant le flux de particules provenant de la rampe 12, bien qu'il puisse en être autrement, sans sortir du cadre de l'invention.

La figure 7 montre l'état de l'installation après le déclenchement du mouvement du substrat 38, initié dès que le front 54 a atteint le niveau requis représenté sur la figure 5, et après le processus de structuration décrit ci-dessus. Le premier film de particules 4, les motifs 70 et les objets 50 ou autres particules 4.1 qui y sont logés se déposent alors ensemble sur le substrat 38, par déplacement simultané à travers la sortie 26, en empruntant le pont capillaire 42, à la manière de celle décrite dans le document CA 2 695 449. En d'autres termes, le déplacement du premier film 4 permet de convoyer les contours des motifs ainsi que les éléments qui se trouvent à l'intérieur de ces motifs, même si le processus de structuration pourrait prévoir de laisser les motifs vides au moment du dépôt sur le substrat, sans sortir du cadre de l'invention.

Comme évoqué ci-dessus, après le dépôt, la largeur du film structuré 4' intégrant les objets 50 correspond à la largeur L1 de la sortie 26, même si une largeur inférieure peut être adoptée, sans sortir du cadre de l'invention.

De façon encore plus préférée, le substrat est directement au contact de la sortie des particules.

Les particules ordonnées 4, situées extérieurement aux motifs 70, recouvrent toute la surface restante du liquide porteur 16 présent dans la zone de transfert. L'ordonnancement est ainsi conservé jusqu'au moment du dépôt à la sortie 26 de la zone 14. La conservation de cet ordonnancement assure le maintien d'un positionnement relatif précis entre les objets 50, ainsi qu'une position précise par rapport aux rebords latéraux fixes 28, jusqu'à ce que le film structuré 4' soit déposé sur le substrat.

Pour faciliter le dépôt et l'adhérence des particules 4, des motifs 70 et des objets 50 ou autres particules 4.1 sur le substrat 38, de préférence réalisé en polymère, il est prévu un recuit thermique postérieurement au transfert. Ce recuit thermique est par exemple réalisé à 80°C, en utilisant un film mat de laminage basse température à base de polyester, par exemple commercialisé sous la référence PERFEX-MATT™, d'épaisseur 125µm.

L'avantage d'un tel film en tant que substrat est que l'une de ses faces devient collante à la température de l'ordre de 80°C, ce qui permet de faciliter l'adhérence des particules 4, 4.1 et des objets 50 sur celle-ci. Cette température étant relativement basse par rapport aux températures d'élaboration des objets visés par l'invention comme les puces en silicium ou les cellules photovoltaïques, la fixation de ces objets peut s'effectuer sans détérioration.

Plus précisément, à cette température, les particules 4 s'enfoncent dans le film ramolli 38, et permettent ainsi un contact direct des objets avec le film, qui conduit à leur collage.

Alternativement, le substrat 38 peut être du type silicium, verre, ou encore film piézoélectrique.

Il est noté qu'après le transfert, que les motifs 70 soient remplis ou non, les cordons polymérisés 72 peuvent être conservés sur le substrat, ou bien être retirés en emportant de préférence avec eux les particules 4 agencées au contact de ces cordons.

Au cours du transfert, l'injection de particules et la vitesse de défilement du substrat sont réglées de sorte que le front de particules reste dans une position sensiblement identique. Pour ce faire, le débit de particules peut être de l'ordre de 0,1 ml/min à plusieurs ml/min, tandis que la vitesse linéaire du substrat 38, également dénommée vitesse de tirage, peut être de l'ordre de quelques mm/min à plusieurs centaines de mm/min. Comme évoqué ci-dessus, l'alimentation en particules 4 peut être stoppée temporairement lors de la réalisation des motifs 70 et/ou lors de l'intégration des objets 50 ou des autres particules 4.1 au sein de ces motifs.

A cet égard, il est noté que les objets à transférer peuvent être de différentes sortes, en fonction des applications désirées. Préférentiellement, chaque objet 50 présente une grande dimension supérieure à 0,2 cm et inférieure ou égale à L1, c'est-à-dire proche 30 cm. L'épaisseur est comprise entre une dizaine de micromètres et plusieurs dizaines de millimètres.

Certains types d'objets à transférer comme les cellules solaires, micro-batteries et composants organiques ont une forme simple de carré, de rectangle, ou encore de disque, avec une faible épaisseur, et une superficie de l'ordre de 0,1 à 100 cm².

Ces composants peuvent comporter des plots ou pinoches sur la face en contact avec le liquide pour procéder à leur connectique. D'autres types objets, visant par exemple la détection d'éléments, la génération d'énergie ou encore le transport de l'information, peuvent avoir des formes complexes, par exemple des parties courbés ou en spirale.

Par ailleurs, le rapport entre la grande dimension des particules 4 et celle des objets 50 est préférentiellement compris entre 10⁴ et 10⁸. En effet, la grande dimension des particules est par exemple de l'ordre de 1 nm à 500 µm, tandis que les objets convoyés 50 peuvent présenter une grande dimension allant jusqu'à environ 30 cm.

De préférence, la face de chaque objet 50 au contact du liquide porteur est à caractère hydrophobe, mais il est également possible de prévoir un agencement de parties hydrophiles et hydrophobes au niveau de cette face. Comme évoqué ci-dessus, la tension superficielle du liquide porteur joue aussi un rôle important dans la flottaison de ces objets.

Le tableau ci-dessous recense quelques exemples préférés pour ces objets 50.

| **Nature** | **Dimensions** | **Domaine d'application** |
|---|---|---|
| Polyéthylène téréphtalate (PET) avec couche d'or structurée en surface | PET : 3x4cm² ; épaisseur 250µm ; PET : 1,5x0,9cm² ; épaisseur 250µm, Au : épaisseur 30nm | Electronique organique |
| Verre avec cellule photovoltaïque en surface | 25x25mm² ; épaisseur 1,08mm | Cellule Photovoltaïque |
| Puce en silicium | 3x3cm² ; épaisseur 500µm 1x1cm² ; épaisseur 500µm | Electronique |
| Micro-batterie sur silicium | 1x1cm² ; épaisseur 500µm | Stockage énergie |
| Matériau métallique bilame (ex. : zinc/cuivre) | 3,5x2cm² ; épaisseur 140µm 5x1,6cm² ; épaisseur 200µm 7x1,6cm² ; épaisseur 200µm | Thermique, capteurs |

En référence à présent aux figures 8a à 8d, il va être décrit un procédé de dépôt selon un second mode de réalisation préféré de l'invention.

La figure 8a est identique à la figure 6a, car ce second mode est initié de la même manière que pour le premier mode décrit ci-dessus, jusqu'à la formation des motifs 70 avec la substance 72. Par conséquent, cette partie du procédé ne sera pas davantage décrit.

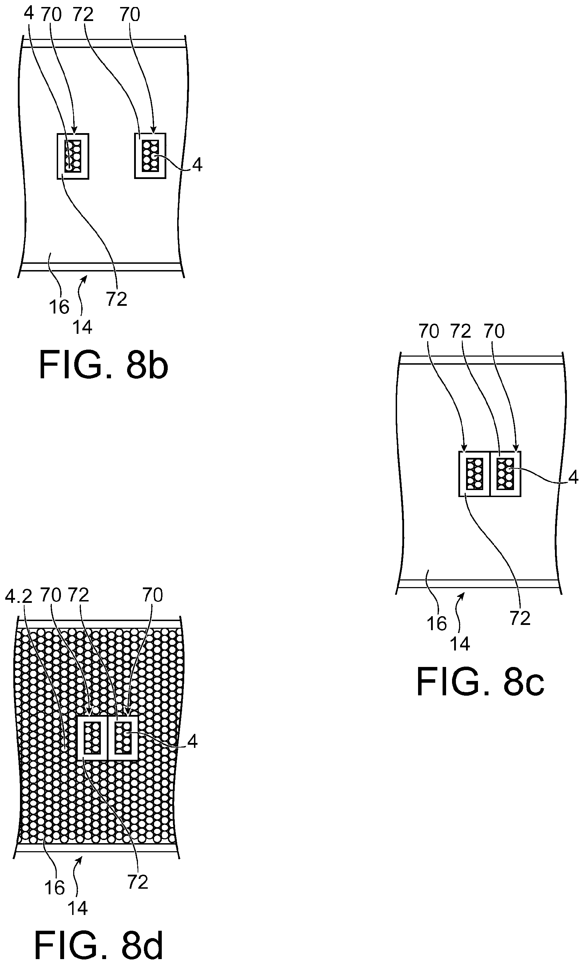

En revanche, en référence à la figure 8b, ce procédé est poursuivi en retirant les particules du premier film 4 qui se trouvent autour des contours fermés 72, de préférence par aspiration. Seules les particules ordonnées 4 situées au sein des motifs 70 sont conservées.

Ensuite, comme cela a été schématisé sur la figure 8c, les motifs 70 sont éventuellement déplacés les uns par rapport aux autres dans la zone de transfert 14 sur le liquide porteur 16, par exemple pour être rapprochés. Les motifs 70, qui conservent leur forme initiale tout au long du processus de structuration, peuvent être déplacés par des pointes appropriées encadrant la forme, ou encore être maintenus à leurs positions initiales également par de telles pointes, jusqu'à l'étape suivante montrée sur la figure 8d. En guise de pointes, des aiguilles d'un diamètre de l'ordre de quelques centaines de microns sont utilisées. Suivant les formes de l'objet à manipuler, trois ou quatre aiguilles sont généralement nécessaires pour stabiliser, positionner ou orienter l'objet. Ces aiguilles peuvent être placées à l'intérieur ou à l'extérieur de l'objet. Ces aiguilles sont elles-mêmes déplacées par exemple par un bras de manipulation avec des déplacements micrométriques. Une fois l'objet positionné et une fois qu'un nouveau film de particules est formé autour de l'objet, les aiguilles peuvent être ôtées sans générer de défaut.

Cette étape consiste à réaliser un second film de particules ordonnées 4.2 dans la zone de transfert 14, autour des motifs 70. La formation du second film 4.2 sur le liquide porteur est identique ou similaire à celle du premier film 4, et ne sera par conséquent pas davantage décrite.

Ensuite, c'est l'ensemble formé par les motifs 70 remplis de particules 4 et le second film 4.2 qui est transféré sur le substrat, en passant par la sortie de particules dédiée à cet effet.

Les particules 4.2 sont ici de préférence différentes en taille et/ou en matériau des particules 4 du premier film. De même, tout comme dans le premier mode de réalisation préféré, la géométrie des motifs peut être variée, adaptée en fonction des besoins rencontrés, éventuellement prévue pour obtenir le dépôt d'un film structuré présentant un ou plusieurs gradients de particules.

Enfin, tout comme pour le mode de réalisation suivant, les cordons de substance polymérisée peuvent être conservés sur le substrat, ou bien retirés.

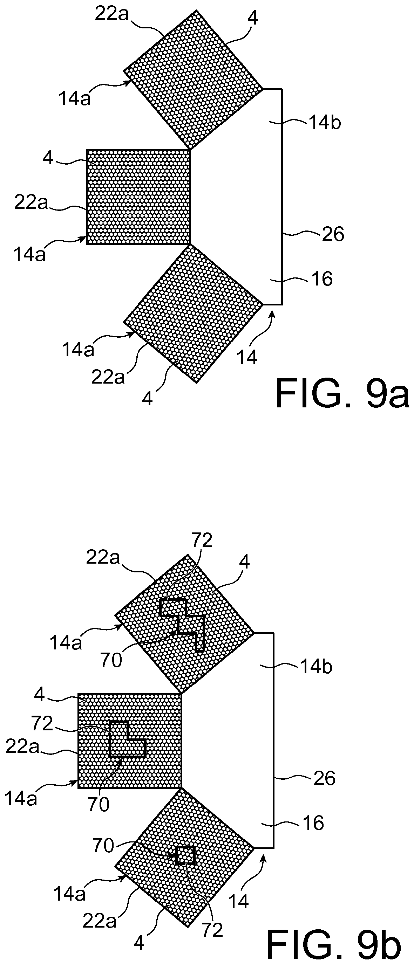

En référence à présent aux figures 9a à 9d, il va être décrit un procédé de dépôt selon un troisième mode de réalisation préféré de l'invention, qui est un dérivé du second mode qui vient d'être présenté.

Pour la mise en oeuvre de ce troisième mode de réalisation préféré, l'installation est légèrement modifiée puisque la zone de transfert est segmentée de manière à présenter plusieurs parties d'entrée séparées 14a, ainsi qu'une partie de sortie 14b. Chaque partie 14a présente une entrée de particules 22a associée à une rampe d'alimentation en particules, ou, alternativement, il est prévu une unique rampe permettant de coopérer successivement avec les entrées 22a de chacune des parties 14. De plus, chaque partie 14a débouche dans la partie de sortie 14b, même si l'accès à celle-ci peut être sélectivement obturé / libéré, sur commande. Enfin, c'est la partie 14b qui définit la sortie de particules 26 destinée à être en regard du substrat.

Tout d'abord, le procédé est réalisé en formant un premier film de particules 4 dans chacune des parties d'entrée 14a de la zone de transfert 14, avec l'accès à la partie de sortie 14b obturé. Une telle configuration est représentée sur la figure 9a, avec des premiers films 4 qui sont ordonnés dans leurs parties respectives 14a de manière à les remplir entièrement, d'une façon identique ou similaire à celle mise en oeuvre pour le premier mode de réalisation, pour l'intégralité de la zone de transfert. L'une des particularités réside ici dans le fait que les particules 4 utilisées peuvent être différentes selon les parties 14a.

Ensuite, un ou plusieurs motifs 70 sont réalisés à l'aide de la substance 72 dans chacune des parties d'entrée 14a, d'une manière identique à celle utilisée pour les modes de réalisation précédents. De tels motifs sont représentés sur la figure 9b.

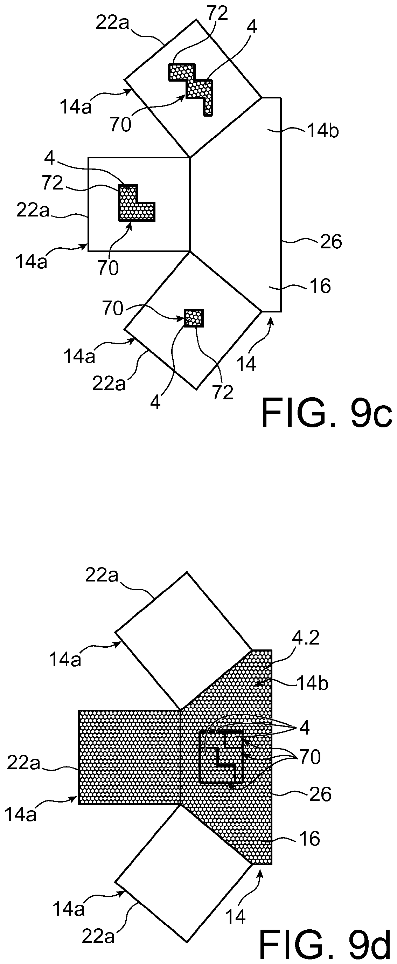

Le processus de structuration est poursuivi, tout comme dans le second mode, en retirant les particules 4 situées extérieurement par rapport aux motifs 70 suivant un contour fermé 72, comme cela est visible sur la figure 9c. Les motifs sont ensuite déplacés, toujours par exemple à l'aide de pointes, et ré-agencés dans la partie de sortie 14b de la zone de transfert, après avoir libéré les accès à cette partie.

Toujours de manière analogue au second mode de réalisation, il est ensuite réalisé un second film de particules ordonnées 4.2 dans la zone de transfert autour des motifs ré-agencés, de préférence dans l'une seulement des parties 14a et dans la partie 14b, comme cela a été schématisé sur la figure 9d.

Après la formation du second film de particules ordonnées 4.2, le transfert sur le substrat s'effectue d'une manière similaire à celle déjà exposée pour le mode de réalisation précédent.

Quel que soit le mode de réalisation envisagé, le procédé peut également comporter une étape de réalisation d'un ou plusieurs cordons ou de points sur le film 4 ou le film 4.2, voire sur les particules 4.1, à l'aide de la substance 72, lorsque ces particules se trouvent sur le liquide porteur dans la zone de transfert. Ce n'est qu'après le dépôt sur le substrat que ces cordons, de préférence suivant une ligne non-fermée, sont éliminés, en laissant des vides qui peuvent ensuite être éventuellement remplis par d'autres éléments. Lors du retrait des cordons/ points de substance polymérisée, celle-ci emporte de préférence avec elle les particules 4 agencées au contact de ces cordons, du fait de l'adhérence entre ces éléments.

Des applications possibles pour les procédés qui viennent d'être décrits ont été mentionnées ci-dessus. Des exemples concrets sont également décrits ci-dessous.

Il peut s'agir de la fabrication de cellules photovoltaïques et de composants de type LED/PLED/OLED. Des études récentes ont montré que la structuration des interfaces dans le domaine des composants photovoltaïques, LED, PLED, OLED pouvait apporter au gain significatif en rendement ou en lumière émise. Dans ce cadre, les films compacts de particules sont par exemple utilisés comme éléments de masquage lors des étapes de structuration des interfaces. Les structurations sont opérées généralement au travers des interstices présents entre les particules par des dépôts de matériaux ou par gravure par plasma. Néanmoins certaines zones du substrat doivent être évidées pour, par exemple, laisser libre les zones de contacts électriques ou simplement parce qu'elles n'ont pas de fonction particulière. Par le procédé selon le premier mode de réalisation décrit ci-dessus, il est donc possible, avant le transfert du film compact sur le substrat, de définir sur le liquide avec la substance les zones devant être vides de particules, puis de les ôter par aspiration.

Un autre exemple concerne les échangeurs thermiques. La structuration des parois des échangeurs est un moyen pour régler les échanges thermiques. Ces structurations sont réalisables par lithographie avec un masque de particules. Avec les procédés décrits ci-dessus, la mise en oeuvre de dépôts hétérogènes associant des particules de différentes dimensions rend possible l'obtention de géométries habituellement réalisées par lithographie, et notamment à des géométries avec des gradients de tailles de particules.

Encore un autre exemple se rapporte aux capteurs chimiques. Les procédés décrits ci-dessus offrent la possibilité d'associer des films compacts hétérogènes avec des particules de différentes natures, et permettent donc la détection de différentes natures de gaz, espèces chimiques, etc.

Enfin, en tribologie, pour les applications mécaniques, des films compacts peuvent être utilisés comme masque de lithographie pour créer des micro/nanocuves permettant la rétention du lubrifiant à la surface des objets en frottement. L'ajustement des dimensions de ces micro/nanocuves de rétention est un paramètre de réglage du coefficient de frottement. Un moyen simple pour changer les dimensions de ces micro/nanocuves est d'utiliser comme masque de gravure un film compact hétérogène composé de différentes tailles de particules, facile à obtenir avec le procédé spécifique à la présente invention.

## Revendications

1. Procédé de dépôt de particules sur un substrat (38), de préférence en défilement, comprenant les étapes suivante :
(a) réalisation d'un moins un premier film compact de particules (4) flottant sur un liquide porteur (16) prévu dans une zone de transfert (14) présentant une sortie de particules (26) agencée en regard dudit substrat (38) ;
(b) réalisation d'au moins un motif (70) par dépôt d'une substance (72) sur ledit premier film compact de particules (4) dans la zone de transfert (14), le long d'un contour dudit motif, ladite substance maintenant les unes aux autres les particules du film (4) au contact de cette substance ;
(c) retrait d'au moins une partie des particules du premier film (4) situées intérieurement par rapport audit contour, ou extérieurement par rapport à ce dernier ; puis
(d) transfert des motifs (70) sur ledit substrat (38), par ladite sortie de particules (26).

2. Procédé selon la revendication 1, dans lequel l'étape (c) consiste à retirer lesdites particules (4) situées intérieurement par rapport à chaque contour (72), cette étape étant éventuellement suivie, avant l'étape (d), d'une étape de mise place d'un ou plusieurs autres éléments (4.1, 50), sur le liquide porteur (16) dans la zone évidée délimitée par chaque contour, l'étape (d) étant réalisée en déplaçant ensemble chaque motif (70) et ledit premier film (4) à travers ladite sortie de particules, et, le cas échéant, avec ledit un ou plusieurs autres éléments (4.1, 50).

3. Procédé selon la revendication 2, dans lequel il est placé, dans chaque zone évidée, au moins un élément (50) pris parmi le groupe des puces en silicium, des micro-batteries, des composants de l'électronique organique, des éléments métalliques, des cellules photovoltaïques, des piles et micro-piles, ou encore d'autres particules.

4. Procédé selon la revendication 1, dans lequel l'étape (c) consiste à retirer lesdites particules situées extérieurement par rapport à chaque contour (72), cette étape étant suivie, avant l'étape (d), d'une étape de réalisation d'un second film compact de particules (4.2) flottant sur le liquide porteur (16) dans la zone de transfert (14), autour de chaque contour (72), l'étape (d) étant réalisée en déplaçant ensemble chaque motif (70) et ledit second film (4.2) à travers ladite sortie de particules (26).

5. Procédé selon la revendication 4, dans lequel ledit second film (4.2) est réalisé à l'aide de particules différentes de celles dudit premier film (4).

6. Procédé selon la revendication 1, dans lequel l'étape (a) consiste à réaliser une pluralité de premiers films compacts de particules (4) respectivement dans différentes parties séparées (14a) de ladite zone de transfert (14), dans lequel l'étape (b) consiste à réaliser au moins un motif (70) sur chaque premier film compact (4), dans lequel l'étape (c) consiste à retirer, dans chacune desdites parties (14a) de ladite zone de transfert, lesdites particules (4) situées extérieurement par rapport à chaque contour (72), dans lequel les motifs (70) sont ensuite éventuellement déplacés relativement les uns par rapport aux autres sur le liquide porteur (16), et dans lequel il est ensuite réalisé, avant l'étape (d), une étape de réalisation d'un second film compact de particules (4.2) flottant sur le liquide porteur (16) dans la zone de transfert (14), autour desdits motifs (70), l'étape (d) consistant à transférer ensemble lesdits motifs (70) et le second film (4.2) à travers ladite sortie de particules (26).

7. Procédé selon la revendication 6, dans lequel ledit second film (4.2) est réalisé à l'aide de particules différentes de celles desdits premiers films (4).

8. Procédé selon l'une quelconque des revendications précédentes, dans lequel ladite substance (72) comprend un composé polymérisable, qui est polymérisé après son dépôt sur le premier film compact de particules (4).

9. Procédé selon l'une quelconque des revendications précédentes, dans lequel ladite substance (72) se présente sous la forme d'un liquide ou d'une pâte.

10. Procédé selon l'une quelconque des revendications précédentes, dans lequel ladite substance (72) présente un caractère hydrophobe.

11. Procédé selon l'une quelconque des revendications précédentes, dans lequel ladite substance (72) est à base de résine silicone, de résine époxy, et/ou de résine polyuréthane.

12. Procédé selon l'une quelconque des revendications précédentes, dans lequel ladite substance (72) comprend au moins certaines particules prises parmi les matériaux suivants :
- noir de carbone ;
- nanotubes de carbone ;
- graphène ;
- fibres, telles que des fibres de carbone, d'acier d'aluminium, de cuivre ;
- poudres métalliques ; et
- des oxydes de métaux.

13. Procédé selon l'une quelconque des revendications précédentes, **caractérisé en ce qu'**il met en oeuvre une rampe inclinée (12) de circulation des particules, rattachée à ladite entrée de la zone de transfert, et sur laquelle ledit liquide porteur (16) est également destiné à circuler.

14. Procédé selon l'une quelconque des revendications précédentes, **caractérisé en ce qu'**il inclut une étape de réalisation d'au moins un cordon / point à l'aide d'une substance (72) déposée sur les particules, ledit cordon étant éliminé après son dépôt sur le substrat.

## Patentansprüche

1. Verfahren zum Aufbringen von Partikeln auf ein vorzugsweise vorbeilaufendes Substrat (38), umfassend die nachfolgenden Schritte:
(a) Herstellen von zumindest einem ersten kompakten Film aus Partikeln (4), die auf einer Trägerflüssigkeit (16) schwimmen, die in einem Überführungsbereich (14) vorgesehen ist, der einen Partikelauslass (26) aufweist, der dem Substrat (38) gegenüberliegend angeordnet ist;
(b) Herstellen zumindest eines Musters (70) durch Aufbringen einer Substanz (72) auf den ersten kompakten Partikelfilm (4) in dem Überführungsbereich (14) entlang einer Kontur des Musters, wobei die Substanz die Partikel des Films (4) in Kontakt mit dieser Substanz zusammenhält;
(c) Entfernen zumindest eines Teils der Partikel aus dem ersten Film (4), die bezüglich der Kontur innen liegen oder bezüglich der letztgenannten außen liegen; dann
(d) Überführen der Muster (70) auf das Substrat (38) über den Partikelauslass (26).

2. Verfahren nach Anspruch 1, wobei der Schritt (c) darin besteht, die Partikel (4) zu entfernen, die bezüglich einer jeden Kontur (72) innen liegen, wobei diesem Schritt gegebenenfalls vor dem Schritt (d) ein Schritt des Anordnens von einem oder mehreren weiteren Elementen (4.1, 50) auf die Trägerflüssigkeit (16) in dem von jeder Kontur eingegrenzten, ausgenommenen Bereich folgt, wobei Schritt (d) dadurch erfolgt, dass jedes Muster (70) und der erste Film (4) gemeinsam durch den Partikelauslass und gegebenenfalls mit dem einen oder mehreren der weiteren Elementen (4.1, 50) verlagert werden.

3. Verfahren nach Anspruch 2, wobei in jeden ausgenommenen Bereich zumindest ein Element (50) angeordnet wird, das ausgewählt ist aus der Gruppe umfassend Siliciumchips, Mikroakkus, Bauteile der organischen Elektronik, metallische Elemente, Solarzellen, Batterien und Mikro-Batterien, oder noch weitere Partikel.

4. Verfahren nach Anspruch 1, wobei der Schritt (c) darin besteht, die bezüglich einer jeden Kontur (72) außen liegenden Partikel zu entfernen, wobei diesem Schritt vor dem Schritt (d) ein Schritt des Herstellens eines zweiten kompakten Films aus Partikeln (4.2) folgt, die auf der Trägerflüssigkeit (16) in dem Überführungsbereich (14) schwimmen, um jede Kontur (72) herum, wobei der Schritt (d) dadurch erfolgt, dass jedes Muster (70) und der zweite Film (4.2) gemeinsam durch den Partikelauslass (26) verlagert werden.

5. Verfahren nach Anspruch 4, wobei der zweite Film (4.2) mit Hilfe von Partikeln hergestellt wird, die sich von denen des ersten Films (4) unterscheiden.

6. Verfahren nach Anspruch 1, wobei Schritt (a) darin besteht, eine Mehrzahl von ersten kompakten Partikelfilmen (4) in jeweils unterschiedenen, getrennten Abschnitten (14a) des Überführungsbereichs (14) herzustellen, wobei Schritt (b) darin besteht, zumindest ein Muster (70) auf jedem ersten kompakten Film (4) herzustellen, wobei Schritt (c) darin besteht, aus jedem der Abschnitte (14a) des Überführungsbereichs Partikel (4) zu entfernen, die bezüglich jeder Kontur (72) außen liegen, wobei die Muster (70) dann gegebenenfalls auf der Trägerflüssigkeit (16) zueinander verlagert werden, und wobei dann vor Schritt (d) ein Schritt des Herstellens eines zweiten kompakten Films von Partikeln (4.2), die auf der Trägerflüssigkeit (16) in dem Überführungsbereich (14) schwimmen, um die Muster (70) herum erfolgt, wobei der Schritt (d) darin besteht, die Muster (70) und den zweiten Film (4.2) gemeinsamen durch den Partikelauslass (26) zu überführen.

7. Verfahren nach Anspruch 6, wobei der zweite Film (4.2) mit Hilfe von Partikeln erfolgt, die sich von denen der ersten Filme (4) unterscheiden.

8. Verfahren nach einem der vorangehenden Ansprüche, wobei die Substanz (72) eine polymerisierbare Verbindung enthält, die nach deren Aufbringen auf den ersten kompakten Partikelfilm (4) polymerisiert wird.

9. Verfahren nach einem der vorangehenden Ansprüche, wobei die Substanz (72) in Form einer Flüssigkeit oder einer Paste vorliegt.

10. Verfahren nach einem der vorangehenden Ansprüche, wobei die Substanz (72) eine hydrophobe Eigenschaft hat.

11. Verfahren nach einem der vorangehenden Ansprüche, wobei die Substanz (72) auf Basis von Silikonharz, Epoxidharz und/oder Polyurethanharz besteht.

12. Verfahren nach einem der vorangehenden Ansprüche, **dadurch gekennzeichnet, dass** die Substanz (72) zumindest bestimmte Partikel ausgewählt aus den folgenden Materialien enthält:
- Ruß;
- Kohlenstoffnanoröhrchen;
- Graphen;
- Fasern, wie etwa Fasern aus Kohlenstoff, aus Aluminium, aus Stahl, aus Kupfer;
- Metallpulver; und
- Metalloxide.

13. Verfahren nach einem der vorangehenden Ansprüche, **dadurch gekennzeichnet, dass** es eine geneigte Rampe (12) zur Zirkulation von Partikeln verwendet, die mit dem Einlass des Überführungsbereichs verbunden ist und auf welcher auch die Trägerflüssigkeit (16) zirkulieren soll.

14. Verfahren nach einem der vorangehenden Ansprüche, **dadurch gekennzeichnet, dass** es einen Schritt des Herstellens zumindest eines Strichs/Punkts mit Hilfe einer Substanz (72) umfasst, die auf die Partikel aufgebracht ist, wobei der Strich nach seinem Aufbringen auf das Substrat beseitigt wird.

## Claims

1. A method for depositing particles onto a substrates (38), preferably a running substrate, comprising the following steps:
(a) producing at least one first compact film of particles (4) floating on a carrier liquid (16) provided in a transfer area (14) having an outlet of particles (26) arranged facing said substrate (38);
(b) producing at least one pattern (70) by depositing a substance (72) on said first compact film of particles (4) in the transfer area (14) along a contour of said pattern, said substance maintaining together the particles of the film (4) in contact with this substance;
(c) removing at least one portion of the particles of the first films (4) located interiorly relatively to said contour or exteriorly relatively to the latter; and then
(d) transferring patterns (70) onto said substrate (38), through said outlet of particles (26).

2. The method according to claim 1, wherein the step (c) consists of removing said particles (4) located interiorly relatively to each contour (72), this step being optionally followed, before step (d), by a step for placing one or several other elements (4.1, 50), onto the carrier liquid (16) in the recessed area delimited by each contour, step (d) being carried out by displacing together each pattern (70) and said first film (4) through said outlet of particles, and, if necessary, with said one or several other elements (4.1, 50).

3. The method according to claim 2, wherein at least one element (50) taken from the group of silicon chips, micro-batteries, components of organic electronics, metal elements, photovoltaic cells, battery cells and micro-battery cells, or further other particles are placed in each recessed area.

4. The method according to claim 1, wherein step (c) consists of removing said particles located exteriorly relatively to each contour (72), this step being followed, before step (d), by a step for making a second compact film of particles (4.2) floating on the carrier liquid (16) in the transfer area (14), around each contour (72), step (d) being carried out by moving together each pattern (70) and said second film (4.2) through said outlet of particles (26).

5. The method according to claim 4, wherein said second film (4.2) is made by means of particles different from those of said first film (4).

6. The method according to claim 1, wherein step (a) consists of producing a plurality of first compact films of particles (4) respectively in different separate portions (14a) of said transfer area (14) wherein step (b) consists of producing at least one pattern (70) on each first compact film (4), wherein step (c) consists of removing, in each of said portions (14a) of said transfer area, said particles (4) located exteriorly relatively to each contour (72), wherein the patterns (70) are then optionally displaced relatively to each other on the carrier liquid (16) and wherein a step for producing a second compact film of particles (4.2) floating on the carrier liquid (16) is then produced before step (d) in the transfer area (14) around said patterns (70), the step (d) consisting of transferring together said patterns (70) and the second film (4.2) through said outlet of particles (26).

7. The method according to claim 6, wherein said second film (4.2) is produced by means of particles different from those of said first films (4).

8. The method according to any of the preceding claims, wherein said substance between (72) comprises a polymerizable compound, which is polymerized after its deposition on the first compact film of particles (4).

9. The method according to any of the preceding claims, wherein said substance (72) appears as a liquid or a slurry.

10. The method according to any of the preceding claims, wherein said substance (72) has hydrophobicity.

11. The method according to any of the preceding claims, wherein said substance (72) is based on a silicon resin, epoxy resin, and/or polyurethane resin.

12. The method according to any of the preceding claims, wherein said substance (72) comprises at least certain particles taken from the following materials:
- carbon black;
- carbon nanotubes;
- graphene;
- fibers, such as carbon, steel, aluminum, copper fiber;
- metal powders; and
- metal oxides.

13. The method according to any of the preceding claims, **characterized in that** it applies a titled ramp (12) for circulation of the particles, attached to said inlet of the transfer area, and on which said carrier liquid (16) is also intended to circulate.

14. The method according to any other preceding claims, **characterized in that** it includes a step for producing at least one cord/spike by means of a substance (72) deposited on the particles, said cord being removed after its deposition on the substrate.
